(19) Europäisches Patentamt
European Patent Office
Office européen des brevets

(11) **EP 2 546 664 B1**

(12) **EUROPÄISCHE PATENTSCHRIFT**

(45) Veröffentlichungstag und Bekanntmachung des Hinweises auf die Patenterteilung:
**23.10.2019 Patentblatt 2019/43**

(51) Int Cl.:
*G01R 27/16* (2006.01)     *G01R 19/00* (2006.01)
*G01R 19/165* (2006.01)     *G01R 1/20* (2006.01)
*G01R 31/00* (2006.01)     *G01R 35/00* (2006.01)

(21) Anmeldenummer: **12174922.0**

(22) Anmeldetag: **04.07.2012**

(54) **Verfahren zur Überprüfung einer Messanordnung zur Spannungsbestimmung und Verfahren zum Laden einer ladbaren Spannungsquelle**

Method for testing a measuring assembly for determining voltage and method for charging a chargeable power source

Procédé de contrôle d'un agencement de mesure destiné à déterminer la tension et procédé de charge d'une source de tension pouvant être chargée

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.07.2011 DE 102011107206**

(43) Veröffentlichungstag der Anmeldung:
**16.01.2013 Patentblatt 2013/03**

(73) Patentinhaber: **thyssenkrupp Marine Systems GmbH**
**24143 Kiel (DE)**

(72) Erfinder:
• **Siegler, Bernd**
**24145 Kiel (DE)**
• **Sievers, Tim**
**24808 Jevenstedt (DE)**

(74) Vertreter: **thyssenkrupp Intellectual Property GmbH**
**ThyssenKrupp Allee 1**
**45143 Essen (DE)**

(56) Entgegenhaltungen:
| | |
|---|---|
| **EP-A1- 2 051 088** | **EP-A2- 1 378 757** |
| **WO-A2-2010/050673** | **DE-A1- 2 915 491** |
| **DE-A1- 2 934 200** | **DE-A1- 3 101 994** |
| **DE-A1- 3 513 848** | **DE-A1- 4 104 172** |
| **DE-A1- 4 411 428** | **DE-A1- 10 245 133** |
| **DE-A1- 19 900 978** | **DE-A1-102009 007 969** |
| **JP-A- H09 112 912** | **US-A1- 2005 248 351** |
| **US-A1- 2007 001 684** | **US-A1- 2008 048 714** |
| **US-A1- 2008 303 605** | **US-A1- 2011 121 789** |
| **US-B1- 6 504 417** | |

• **ROD WHITE ET AL: "A Simple Resistance Network for Calibrating Resistance Bridges", IEEE TRANSACTIONS ON INSTRUMENTATION AND MEASUREMENT, IEEE SERVICE CENTER, PISCATAWAY, NJ, US, Bd. 46, Nr. 5, 1. Oktober 1997 (1997-10-01), XP011024378, ISSN: 0018-9456**

## Beschreibung

Die Erfindung betrifft ein Verfahren zur Überprüfung einer Messanordnung zur Spannungsbestimmung und ein Verfahren zum Laden einer ladbaren Spannungsquelle.

Es ist bekannt, Spannungsquellen mit einer Messanordnung zur Spannungsbestimmung zu versehen. Spannungsbestimmungen und damit einhergehend die Bestimmung des Ladungszustandes von Spannungsquellen sind oftmals erforderlich, um die Spannungsquelle sicher zu betreiben. Ein sicherer Betrieb von Spannungsquellen ist insbesondere bei solchen Spannungsquellen, die ein Bordstromnetz eines Unterseebootes mit elektrischer Energie versorgen, von hoher Relevanz. Denn in diesem Fall hält sich die Besatzung eines Unterseebootes notwendig dauerhaft in unmittelbarer Nähe der Spannungsquelle auf. Folglich ist zum sicheren Betrieb der Spannungsquelle die Spannung und damit auch der Ladezustand der Spannungsquelle fortwährend zu überwachen.

Mit zunehmendem Betriebsalter der Messanordnung können jedoch Kontakte und leitende Verbindungen der Messanordnung, wie etwa vorhandene Messleitungen und Leitungskontakte, korrodieren oder sonst in ihrer Leitfähigkeit beeinträchtigt sein. Eine präzise Spannungs-überwachung und damit ein sicherer Betrieb der Spannungsquelle sind damit erschwert.

Eine genaue Spannungsbestimmung der Spannungsquelle ist auch beim Laden von ladbaren Spannungsquellen wichtig. Denn auch ein sicheres Laden einer solchen Spannungsquelle hängt von einer genauen Bestimmung des Ladezustandes der Spannungsquelle ab. Dabei erfolgt die Bestimmung des Ladezustandes ebenfalls regelmäßig über eine Spannungsbestimmung. Eine fehlerhafte Spannungsbestimmung der Spannungsquelle erschwert daher auch ein sicheres Laden der Spannungsquelle.

Es ist bekannt, zur genauen Spannungsbestimmung zusätzliche Messanordnungen zur Spannungsbestimmung vorzusehen. Solche redundanten Messanordnungen sind jedoch konstruktiv aufwändig.

Das Dokument EP 1 378 757 A2 beschreibt ein Verfahren und eine Anordnung, mit denen der Ladezustand einer Batterie, beispielsweise für ein Gerät oder ein Fahrzeug, ermittelt werden kann. Dies erfolgt über die Widerstandsmessung an einem in Serie zu der Batterie geschalteten Messwiderstand.

Das Dokument JP H09 112912 A beschreibt eine Schaltung mit einem NTC-Widerstand zur thermischen Absicherung eines Gasbrenners. Bei der Schaltung geht es darum, die Differenz zwischen einem ersten Spannungsbereich und einem zweiten Spannungsbereich so zu wählen, dass ein Spannungsabfall infolge eines Bauteilversagens oder einer Veränderung der B-Konstante des NTC-Widerstandes vernachlässigt werden kann.

Das Dokument DE 44 11 428 A1 beschreibt eine Schaltung mit einem Referenzwiderstand und zwei Messwiderständen. Hierdurch kann die Schaltung zur Messung zweier unterschiedlicher physikalischer Parameter eingesetzt werden, bspw. Temperatur, Druck.

Das Dokument US 2011/121789 A1 beschreibt eine Ladeanordnung für das Laden von Batteriezellen, bei der eine Ladespannung der Batteriezellen erfasst wird.

Das Dokument US 6 504 417 B1 beschreibt eine Schaltung für eine Widerstandsmessung eines IC-Bauelements.

Es ist daher Aufgabe der Erfindung, ein verbessertes Verfahren zur Überprüfung einer Messanordnung zur Spannungsbestimmung und ein verbessertes Verfahren zum Laden einer ladbaren Spannungsquelle bereitzustellen. Insbesondere sollen die Verfahren einfach und zuverlässig sein.

Diese Aufgabe wird mit einem Verfahren zur Überprüfung einer Messanordnung zur Spannungsbestimmung mit den in Anspruch 1 angegebenen Merkmalen sowie mit einem Verfahren zum Laden einer ladbaren Spannungsquelle mit den in Anspruch 8 angegebenen Merkmalen gelöst. Bevorzugte Weiterbildungen der Erfindung sind in den zugehörigen Unteransprüchen, der nachfolgenden Beschreibung und der Zeichnung angegeben.

Das erfindungsgemäße Verfahren zur Überprüfung einer Messanordnung zur Spannungsbestimmung dient zur Überprüfung einer solchen Messanordnung zur Spannungsbestimmung, bei welcher ein Spannungsmesser mittels elektrischer Leitungen mit einer Spannungsquelle verbunden ist. Bei dem erfindungsgemäßen Verfahren wird ein auf einen ersten und einen zweiten Referenzwiderstand stellbarer Stellwiderstand genutzt, welcher parallel zum Spannungsmesser angebunden ist. Erfindungsgemäß wird bei dem Verfahren mithilfe aufeinanderfolgender Spannungsmessungen bei erstem und zweitem gestellten Referenzwiderstand des Stellwiderstandes zumindest eine der elektrischen Leitungen zwischen Spannungsquelle und Spannungsmesser geprüft.

Mittels des erfindungsgemäßen Verfahrens werden die aufeinanderfolgend bei dem auf den ersten und den zweiten Referenzwiderstand gestellten Stellwiderstand mittels des Spannungsmessers gemessenen Spannungen erfasst. Ein bei dem auf den ersten Referenzwiderstand gestellten Stellwiderstand erfasster Spannungswert kann mit dem ersten Referenzwiderstand in Beziehung gesetzt werden. Der bei dem auf den zweiten Referenzwiderstand gestellten Stellwiderstand erfasste Spannungswert kann mit dem zweiten Referenzwiderstand in Beziehung gesetzt werden. Zweckmäßig sind erster und zweiter Referenzwiderstand jeweils zeitlich konstant und/oder bekannt. Somit können aus den gemessenen Spannungswerten zwei mathematische Beziehungen erhalten werden, welche zum Überprüfen der Messanordnung genutzt werden können. Insbesondere lassen sich Parameter derjenigen elektrischen Leitungen, mittels welchen Spannungsquelle und Spannungsmesser verbunden sind, vorzugsweise deren elektrischer Widerstand, bestimmen. Eine Korrosion oder ein geänderter elektrischer Widerstand dieser elektrischen Leitungen können folglich aus der Erfassung der mittels des Spannungsmessers erfassten Spannungen ermittelt werden. Mittels des erfindungsgemäßen Verfahrens kann also eine Diagnose für den Zustand insbesondere der elektrischen Leitungen einfach und sicher durchgeführt werden. Insbesondere können die Toleranzen für die erfassten Spannungen für eine zuverlässige Überprüfung der Messanordnung hinreichend klein gewählt werden. Daraus folgt entsprechend eine hohe Trennschärfe bei der Bestimmung der elektrischen Widerstände der elektrischen Leitungen. Damit kann eine besonders zuverlässige Überprüfung der Spannungsbestimmung mit der Messanordnung erfolgen.

Bevorzugt wird bei dem erfindungsgemäßen Verfahren der Stellwiderstand mit einem elektrischen Widerstand und einem an diesen in Reihe angebundenen Schalter gebildet. Dabei wird der erste Referenzwiderstand gestellt, indem der Schalter geöffnet wird. Der zweite Referenzwiderstand wird gestellt, indem der Schalter geschlossen wird. Zweckmäßig ist in dieser Weiterbildung der Erfindung der erste Referenzwiderstand bei geöffnetem Schalter ein praktisch unendlich hoher elektrischer Widerstand, d. h. der elektrische Widerstand des Stellwiderstands ist größer als 10 Gigaohm und/oder größer als ein Messwiderstand des Spannungsmessers. Damit führt der Stellwiderstand bei geöffnetem Schalter keinen oder nur einen vernachlässigbar geringen Strom. Folglich lässt sich in dieser Weiterbildung der Spannungswert bei erstem gestellten Referenzwiderstand erfassen ohne dass dabei die Spannungsquelle nennenswert belastet wird. Bei geschlossenem elektrischen Schalter hingegen ist der elektrische Widerstand des Stellwiderstandes gleich dem elektrischen Widerstand des an dem Schalter in Reihe angebundenen elektrischen Widerstandes. Geeigneterweise ist dieser Widerstand deutlich kleiner als ein Messwiderstand des Spannungsmessers und insbesondere kleiner als 1 Gigaohm, vorzugsweise kleiner als 100 Ohm.

Zweckmäßig ist der Schalter des Stellwiderstands mit einem elektronischen Schalter gebildet, beispielsweise mit einem Transistor. Der Schalter lässt sich in diesem Falle besonders einfach elektronisch und mit hoher Schaltfrequenz ansteuern.

In einer vorteilhaften Weiterbildung des erfindungsgemäßen Verfahrens ist der Stellwiderstand an einer oder den elektrischen Leitungen jeweils potentialgleich einem Potential des Spannungsmessers angebunden.

Insbesondere ist der Stellwiderstand an denjenigen elektrischen Leitungen angebunden, mittels welchen der Spannungsmesser an die Spannungsquelle angebunden ist. In diesem Falle sind mit dem Verfahren vorteilhaft diejenigen Leitungsabschnitte vollständig, d.h. über ihre gesamte Länge überprüfbar, welche jeweils zwischen der Anbindung des Stellwiderstands und der Spannungsquelle gelegen sind. Ist der Stellwiderstand potentialgleich einem Potential des Spannungsmessers angebunden, so ist der mittels des erfindungsgemäßen Verfahrens vollständig überprüfbare Abschnitt der elektrischen Leitung jeweils von der gesamten elektrischen Leitung gebildet.

Geeigneterweise werden bei dem erfindungsgemäßen Verfahren die Ergebnisse der Spannungsmessungen zur Bestimmung eines Leitungswiderstandes einer oder der elektrischen Leitungen, mittels welcher Spannungsmesser und Spannungsquelle miteinander verbunden sind, herangezogen. Mittels des Leitungswiderstandes kann zuverlässig beurteilt werden, ob die Leitungen beschädigt oder korrodiert sind.

Insbesondere wird/werden bei dem erfindungsgemäßen Verfahren die Ergebnisse der Spannungsmessungen und/oder deren Verhältnis und/oder Differenz und/oder der bestimmte Leitungswiderstand einem Vergleich mit vorbestimmten Vergleichswerten unterzogen. Dabei wird das Ergebnis dieses Vergleichs zur Beurteilung einer Veränderung des Leitungswiderstandes herangezogen.

Geeigneterweise werden bei dem Verfahren für eine oder mehrere der vorgenannten Größen Vergleichswerte in Form von unteren und/oder oberen Grenzen herangezogen. Zur Beurteilung einer Veränderung des Leitungswiderstandes wird dann vorteilhaft bestimmt, ob eine oder mehrere der vorgenannten Größen Werte jenseits der Grenzen angenommen haben.

Vorteilhaft wird das erfindungsgemäße Verfahren zur Überprüfung einer Messanordnung zur Spannungsbestimmung an zumindest einer Batterie oder -Batteriezelle, insbesondere einer Lithium-Ionen-Batterie oder -Batteriezelle, durchgeführt. Gerade bei den vorgenannten Spannungsquellen ist eine zuverlässige Überprüfung einer Messanordnung zur Spannungsmessung besonders sicherheitskritisch, da unzuverlässig arbeitende Messanordnungen zu fehlerhaften Spannungsbestimmungen führen können. Bei fehlerhaften Spannungsbestimmungen sind jedoch ordnungsgemäßer Betrieb und ordnungsgemäßes Laden nicht gewährleistet, sodass die vorgenannten Batterien oder Batteriezellen beschädigt oder sogar zerstört werden können. Zudem kann in einem solchen Fall die Umgebung in Mitleidenschaft gezogen werden. Mit dem erfindungsgemäßen Verfahren hingegen kann gerade bei sicherheitskritischen Spannungsquellen eine Überprüfung einer Messanordnung zur Spannungsbestimmung besonders einfach und zuverlässig erfolgen. Die Betriebssicherheit des Betriebs der Spannungsquelle ist mit dem erfindungsgemäßen Verfahren folglich deutlich erhöht. Zweckmäßigerweise wird das erfindungsgemäße Verfahren zur Überprüfung einer Messanordnung zur Spannungsbestimmung an mehreren und insbesondere sämtlichen Batteriezellen dieser Batterie durchgeführt.

Zweckmäßig wird bei dem Verfahren ein Spannungsmesser mit einem Messwiderstand von mindestens einem Gigaohm genutzt. Alternativ oder zusätzlich ist bei dem erfindungsgemäßen Verfahren der zweite Referenzwiderstand vorteilhaft größer/gleich 1 Ohm und/oder kleiner/gleich 10 Ohm, insbesondere 2 Ohm. Bevorzugt wird das erfindungsgemäße Verfahren an einer Spannungsquelle mit einem Innenwiderstand größer/gleich 0,1 Milliohm und/oder kleiner/gleich 1 Milliohm durchgeführt. Insbesondere wird das Verfahren zur Überprüfung einer Messanordnung zur Spannungsbestimmung einer Spannungsquelle durchgeführt, welche zur Speisung eines Bordstromnetzes eines Unterseebootes mit elektrischer Energie ausgebildet ist.

Vorteilhaft wird bei dem erfindungsgemäßen Verfahren der Stellwiderstand, vorzugsweise für eine Zeitdauer von zumindest 3 und/oder höchstens 30 Millisekunden, zumindest 1, insbesondere 10 mal je Sekunde auf den zweiten Referenzwiderstand gestellt. Mittels dieser Weiterbildung des Verfahrens kann eine Überprüfung der Messanordnung zeitlich fortlaufend erfolgen. Auf diese Weise kann zeitnah während des Betriebes oder des Ladens der Spannungsquelle festgestellt werden, ob die Messanordnung in vorgesehener Weise arbeitet. Wird festgestellt, dass die Messanordnung nicht in vorgesehener Weise arbeitet, können wird/werden zweckmäßig nachfolgend Laden und/oder Betrieb der Spannungsquelle abhängig vom Ergebnis der Überprüfung geeignet angepasst oder beendet.

Bei dem erfindungsgemäßen Verfahren zum Laden einer ladbaren Spannungsquelle wird eine Messanordnung zur Spannungsbestimmung dieser Spannungsquelle genutzt. Bei dem Verfahren wird zunächst eine Überprüfung der Messanordnung nach einem der vorhergehenden Verfahren vorgenommen. Nachfolgend wird die Spannungsquelle abhängig von einem Ergebnis dieser Überprüfung geladen. Bevorzugt wird bei dem erfindungsgemäßen Verfahren dann, wenn bei dem Verfahren zur Überprüfung der Messanordnung festgestellt wird, dass Parameter der Messanordnung Werte jenseits vorgegebener Grenzen angenommen haben, das Laden der Spannungsquelle an diese Parameter geeignet angepasst oder abgebrochen.

Besonders bevorzugt werden die vorgenannten erfindungsgemäßen Verfahren auf einem Unterseeboot durchgeführt. Die Betriebssicherheit insbesondere einer das Bordstromnetz eines Unterseebootes speisenden Spannungsquelle und damit die Betriebssicherheit des Unterseebootes sind damit deutlich erhöht.

Nachfolgend wird die Erfindung anhand eines in der Zeichnung dargestellten Ausführungsbeispiels näher erläutert.

Die einzige Zeichnungsfigur 1 zeigt eine Lithium-Ionen-Batteriezelle mit einer Messanordnung zur Spannungsbestimmung dieser Lithium-Ionen-Batteriezelle.

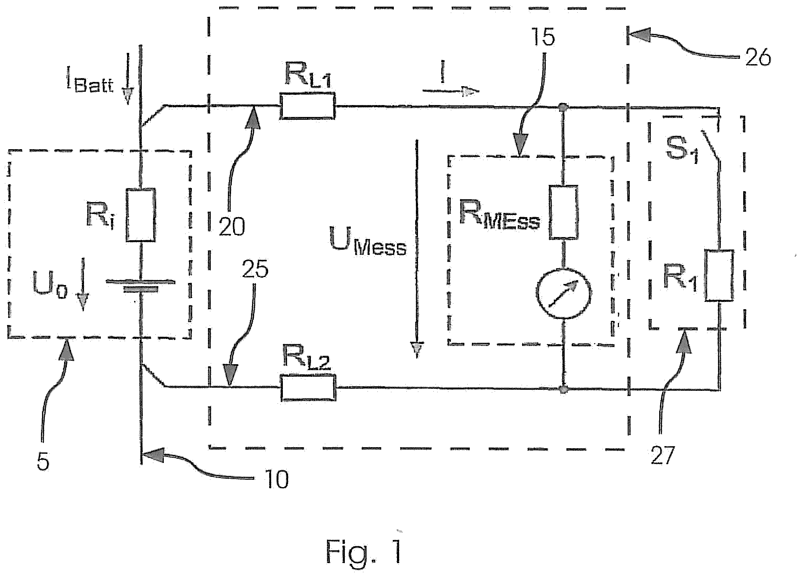

Die in Fig. 1 dargestellte Lithium-Ionen-Batteriezelle 5 ist Teil eines Verbundes von Lithium-Ionen-Batteriezellen (die übrigen Lithium-Ionen-Batteriezellen sind in Fig. 1 nicht dargestellt). Dieser Verbund von Lithium-Ionen-Batteriezellen bildet eine Lithium-Ionen-Batterie, welche zur Versorgung eines Bordstromnetzes eines Unterseebootes (nicht dargestellt) mit elektrischer Energie dient. Die dargestellte Lithium-Ionen-Batteriezelle 5 weist einen Innenwiderstand von 0,5 Milliohm auf (in Fig. 1 als Ersatzschaltbild dargestellt).

Die Lithium-Ionen-Batteriezelle 5 ist mittels elektrischer Leitungen 10 in den Verbund von Lithium-Ionen-Batteriezellen eingebunden. An diesen elektrischen Leitungen 10 ist ein Spannungsmesser 15 mittels zweier Messleitungen 20, 25 parallel zur Lithium-Ionen-Batteriezelle 5 angebunden.

Der Spannungsmesser 15 weist einen Messwiderstand $R_{MEss}$ von 5 Gigaohm auf. Der Spannungsmesser 15 und die beiden Messleitungen 20, 25 bilden eine Messanordnung 26 zur Bestimmung der Spannung der Lithium-Ionen-Batteriezelle 5.

Das zunächst beschriebene Verfahren dient zur Überprüfung der aus Spannungsmesser 15 und Messleitungen 20, 25 gebildeten Messanordnung 26 zur Spannungsbestimmung der Lithium-Ionen-Batteriezelle 5. Das Verfahren wird dabei auf einem Unterseeboot durchgeführt. Das hier beschriebene Verfahren kann jedoch auch an einer beliebigen sonstigen Spannungsquelle und/oder unabhängig von Unterseebooten durchgeführt werden.

Parallel zum Spannungsmesser ist an die Messleitungen 20, 25 ein Stellwiderstand 27 angebunden, der in dem gezeigten Ausführungsbeispiel durch eine Serienschaltung eines Schalters S1 und eines elektrischen Widerstandes $R_1$ gebildet ist (in nicht gesondert dargestellten Ausführungsbeispielen kann der Stellwiderstand 27 auch durch einen anderen stellbaren Stellwiderstand gebildet sein). Der Schalter $S_1$ ist im gezeigten Ausführungsbeispiel als elektronischer Schalter in Form eines Transistors ausgebildet. Der Schalter kann auch auf andere Weise ausgebildet sein (nicht eigens gezeigt). Der elektrische Widerstand $R_1$ beträgt 2 Ohm.

Beim erfindungsgemäßen Verfahren zur Überprüfung einer Messanordnung zur Spannungsbestimmung wird die Anbindung des Spannungsmessers 15 über die Messleitungen 20, 25 an die Lithium-Ionen-Batteriezelle 5 überprüft. Dabei wird zunächst die Summe des elektrischen Widerstands $R_{L1}$ der Messleitung 20 und des elektrischen Widerstands $R_{L2}$ der Messleitung 25 bestimmt und nachfolgend geprüft, ob diese Summe der elektrischen Widerstände $R_{L1}$, $R_{L2}$ innerhalb vorbestimmter Grenzen liegt.

Für die nachfolgende weitere Erläuterung des erfindungsgemäßen Verfahrens wird vereinfachend vorausgesetzt, dass der elektrische Widerstand $R_1$ des Stellwiderstandes 27 zeitlich konstant ist. Ferner wird angenommen, dass dieser elektrische Widerstand $R_1$ kleiner ist als die Summe des elektrischen Widerstandes $R_{L1}$ der ersten Messleitung 20 und des elektrischen Widerstandes $R_{L2}$ der zweiten Messleitung 25. Ferner ist infolge der hier gewählten Widerstandswerte der elektrische Widerstand $R_1$ sehr viel kleiner als der Messwiderstand $R_{Mess}$. Weiterhin wird angenommen, dass der Strom I durch die Lithium-Ionen-Batteriezelle 5, $I_{Batt}$, Null ist.

Bei dem Verfahren werden zur Überprüfung der Messanordnung 26 die mittels des Spannungsmessers 15 gemessenen Spannungswerte $U_{Mess}$ bei geöffnetem und bei geschlossenem Schalter $S_1$ herangezogen. Dabei wird bei dem Verfahren zunächst der Schalter $S_1$ geöffnet und ein erster Spannungswert $U_{Mess1}$ mittels des Spannungsmessers 15 bei geöffnetem Schalter $S_1$ gemessen. Dabei stellt sich an dem Spannungsmesser 15 als erster Spannungswert $U_{Mess1}$ die Leerlaufspannung Uo der Lithium-Ionen-Batteriezelle 5 ein.

Nachfolgend wird der Schalter $S_1$ geschlossen, sodass parallel zum Spannungsmesser 15 der Widerstand $R_1$ des Stellwiderstandes 27 anliegt. Bei geschlossenem Schalter S1 wird nun mittels des Spannungsmessers 15 ein zweiter Spannungswert $U_{Mess2}$ bestimmt.

Erster Spannungswert $U_{Mess1}$ und zweiter Spannungswert $U_{Mess2}$ werden nachfolgend einer weiteren Berechnung unterzogen. Dabei gilt mit dem Strom I durch die Messanordnung und nach der Maschenregel:

$$U_{Mess2} = U_0 - (R_{L1} + R_{L2} + R_i) * I.$$

Hieraus ergibt sich mit $I = R_1/U_{Mess2}$ und $U_0 = U_{Mess1}$:

$$R_{L1} + R_{L2} = (U_{Mess2}/U_{Mess1} - 1)*R_1 - R_i.$$

Folglich lässt sich aus der Kenntnis von $U_{Best1}$ und $U_{Best2}$ die Summe $R_{L1} + R_{L2}$ der Widerstände der Messleitungen 20, 25 bestimmen.

Die derart bestimmte Summe $R_{L1} + R_{L2}$ der Widerstände der Messleitungen 20, 25 wird nun mit vorbestimmten Grenzen verglichen. Überschreitet die Summe $R_{L1} + R_{L2}$ der Widerstände der Messleitungen 20, 25 eine obere Grenze, so wird hieraus geschlossen, dass einer der oder beide Messleitungen 20, 25 oder eine der oder beide Anbindungen der Messleitungen 20, 25 an die elektrischen Leitungen 10 defekt sind. Alternativ oder zusätzlich werden die gemessenen Spannungswerte $U_{mess2}$, $U_{Mess1}$ ins Verhältnis oder eine Differenz gesetzt und es wird bestimmt, ob der Wert dieses Verhältnis oder der Differenz der gemessenen Spannungswerte jenseits einer oder mehrerer vorbestimmter Grenzen liegt. Liegt das Verhältnis oder die Differenz jenseits dieser einen oder mehreren Grenzen, so wird hieraus geschlossen, dass die Messleitungen 20, 25 oder ihre Anbindungen an die elektrischen Leitungen 10 defekt sind.

Der Schalter $S_1$ des Stellwiderstandes 27 wird dabei je zehn mal je Sekunde geöffnet und wieder geschlossen. Die Bestimmung der Spannungswerte $U_{mess2}$, $U_{mess1}$ erfolgt dabei nach jedem Wechsel der Stellung des Schalters $S_1$.

Das erfindungsgemäße Verfahren zum Laden einer ladbaren Batterie wird bei dem nachfolgend erläuterten Ausführungsbeispiel zum Laden der Lithium-Ionen-Batteriezelle 5 durchgeführt. Bei dem Verfahren wird zunächst das zuvor erläuterte Verfahren zur Überprüfung der Messanordnung 26 zur Spannungsbestimmung durchgeführt. Abhängig von dem Ergebnis dieser Prüfung wird die Lithium-Ionen-Batteriezelle 5 geladen. Im gezeigten Ausführungsbeispiel wird das Laden der Lithium-Ionen-Batteriezelle 5 abgebrochen, wenn die zuvor erläuterten Verfahren zur Überprüfung der Messanordnung 26 zur Spannungsbestimmung ergibt, dass die Messleitungen 20, 25 oder deren Anbindungen an die Lithium-Ionen-Batteriezelle 5 defekt sind. Alternativ wird der Ladevorgang auch an die ermittelten Widerstandswerte für die elektrischen Leitungen 20, 25 angepasst.

Es versteht sich, dass anstelle einer Lithium-Ionen-Batteriezelle 5 die vorgenannten erfindungsgemäßen Verfahren auch an anderen Spannungsquellen, etwa an einer ganzen Lithium-Ionen-Batterie, oder an sonstigen Batteriezellen oder Batterien, auch unabhängig von Unterseebooten, durchgeführt werden können.

In nicht eigens dargestellten Ausführungsbeispielen ist der Spannungsmesser direkt an einen Anschluss der Lithium-Ionen-Batteriezelle 5 angebunden. In diesem Ausführungsbeispiel werden die Verfahren wie oben beschrieben durchgeführt. In diesem Falle ist allerdings anstelle der beiden Messleitungen 20, 25 leglich eine einzige Messleitung vorhanden. In diesem Falle wird also nicht der elektrische Widerstand von zwei Messleitungen überprüft, sondern die Summe von Widerständen der einzigen Messleitung und der Anbindung des Spannungsmessers an die Lithium-Ionen-Batteriezelle.

**Bezugszeichen**

| | |
|---|---|
| 5 | - Lithium-Ionen-Batteriezelle |
| 10 | - elektrische Leitungen |
| 15 | - Spannungsmesser |
| 20 | - Messleitung |
| 25 | - Messleitung |
| 26 | - Messanordnung |
| 27 | - Stellwiderstand |
| $R_{MEss}$ | - Messwiderstand |
| $R_{L1}$ | - Widerstand der ersten Messleitung |
| $R_{L2}$ | - Widerstand der zweiten Messleitung |
| $U_{Mess}$ | - Spannungswerte |

$U_{Mess1}$        - Spannungswert

$U_{Mess2}$        - Spannungswert

$S_1$              - Schalter

$R_1$              - elektrischer Widerstand

$R_i$              - Innenwiderstand

$U_0$              - Leerlaufspannung

$I$                - Strom

$I_{Batt}$         - Strom

**Patentansprüche**

1.  Verfahren zur Überprüfung einer Messanordnung (26) zur Spannungsbestimmung, bei der ein Spannungsmesser (15) mittels elektrischer Leitungen (20, 25) mit einer Spannungsquelle (5) verbunden ist und bei welchem ein auf einen ersten und einen zweiten (R1) Referenzwiderstand stellbarer Stellwiderstand (27) parallel zum Spannungsmesser (15) angebunden ist, wobei mithilfe aufeinanderfolgender Spannungsmessungen bei erstem und zweitem (R1) gestellten Referenzwiderstand des Stellwiderstandes (27) zumindest eine der elektrischen Leitungen (20, 25) zwischen Spannungsquelle (5) und Spannungsmesser (15) geprüft wird, **dadurch gekennzeichnet, dass** die Ergebnisse der Spannungsmessungen zur Bestimmung eines Leitungswiderstandes (RL1, RL2) einer oder der elektrischen Leitungen (20, 25), mittels welcher Spannungsmesser (15) und Spannungsquelle (5) miteinander verbunden sind, herangezogen wird.

2.  Verfahren nach Anspruch 1, bei welchem der Stellwiderstand (27) mit einem elektrischen Widerstand (R1) und einem an diesen in Reihe angebundenen Schalter (S1) gebildet ist, wobei der erste Referenzwiderstand gestellt wird, indem der Schalter (S1) geöffnet wird und der zweite (R1) Referenzwiderstand gestellt wird, indem der Schalter (S1) geschlossen wird.

3.  Verfahren nach Anspruch 1 oder 2, bei welchem der Stellwiderstand (27) an einer oder den elektrischen Leitungen (20, 25) jeweils potentialgleich einem Potential des Spannungsmessers (15) angebunden ist.

4.  Verfahren nach einem der Ansprüche 1 bis 3, bei welchem die Ergebnisse der Spannungsmessungen und/oder deren Verhältnis und/oder Differenz und/oder der Leitungswiderstand (RL1, RL2) einem Vergleich mit vorbestimmten Vergleichswerten unterzogen wird/werden, wobei das Ergebnis dieses Vergleichs zur Beurteilung einer Veränderung des Leitungswiderstandes (RL1, RL2) herangezogen wird.

5.  Verfahren nach einem der vorhergehenden Ansprüche, welches zur Überprüfung einer Messanordnung zur Spannungsbestimmung an zumindest einer Batterie oder -Batteriezelle, insbesondere einer Lithium-Ionen-Batterie oder -Batteriezelle (5), durchgeführt wird.

6.  Verfahren nach einem der vorhergehenden Ansprüche, bei welchem ein Spannungsmesser (15) mit einem Messwiderstand ($R_{MEss}$) von mindestens einem Gigaohm genutzt wird und/oder bei welchem der zweite (R1) Referenzwiderstand größer/gleich 1 Ohm und/oder kleiner/gleich 10 Ohm, insbesondere 2 Ohm ist und/oder welches an einer Spannungsquelle mit einem Innenwiderstand (Ri) größer/gleich 0,1 Milliohm und/oder kleiner/gleich 1 Milliohm durchgeführt wird.

7.  Verfahren nach einem der vorhergehenden Ansprüche, bei welchem der Stellwiderstand (27), vorzugsweise für eine Zeitdauer von zumindest 3 und/oder höchstens 30 Millisekunden, zumindest 1, insbesondere 10 mal je Sekunde auf den zweiten Referenzwiderstand (R1) gestellt wird.

8.  Verfahren zum Laden einer ladbaren Spannungsquelle (5), bei welchem eine Messanordnung (26) zur Spannungsbestimmung dieser Spannungsquelle (5) genutzt wird und bei welchem zunächst eine Überprüfung der Messanordnung (26) nach einem der vorhergehenden Verfahren vorgenommen wird, wobei die Spannungsquelle (5) nachfolgend abhängig von einem Ergebnis dieser Überprüfung geladen wird.

9.  Verfahren nach einem der vorhergehenden Ansprüche, welches auf einem Unterseeboot durchgeführt wird.

**Claims**

1.  Method for checking a measuring arrangement (26) for determining voltage, in which a voltmeter (15) is connected to a voltage source (5) by means of electrical lines (20, 25), and in which a rheostat (27) which can be set to a first and a second reference resistance (R1) is connected in parallel with the voltmeter (15), wherein at least one of the electrical lines (20, 25) between the voltage source (5) and the voltmeter (15) is tested with the aid of successive voltage measurements when the first and second reference resistance (R1) of the rheostat (27) is set, **charac-**

**terized in that** the results of the voltage measurements are used to determine a line resistance (RL1, RL2) of one electrical line or of the electrical lines (20, 25), by means of which the voltmeter (15) and the voltage source (5) are connected to one another.

2. Method according to Claim 1, in which the rheostat (27) is formed with an electrical resistor (R1) and a switch (S1) connected in series with the latter, wherein the first reference resistance is set by opening the switch (S1) and the second reference resistance (R1) is set by closing the switch (S1).

3. Method according to Claim 1 or 2, in which the rheostat (27) is connected to one electrical line or to the electrical lines (20, 25) in each case with a potential equal to a potential of the voltmeter (15).

4. Method according to one of Claims 1 to 3, in which the results of the voltage measurements and/or their ratio and/or difference and/or the line resistance (RL1, RL2) is/are subjected to a comparison with predetermined comparison values, wherein the result of this comparison is used to assess a change in the line resistance (RL1, RL2).

5. Method according to one of the preceding claims, which is carried out in order to check a measuring arrangement for determining voltage at at least one battery or battery cell, in particular a lithium ion battery or battery cell (5).

6. Method according to one of the preceding claims, in which a voltmeter (15) having a measurement resistance ($R_{MEss}$) of at least one gigaohm is used and/or in which the second reference resistance (R1) is greater than/equal to 1 ohm and/or less than/equal to 10 ohms, in particular is 2 ohms, and/or which is carried out at a voltage source having an internal resistance (Ri) of greater than/equal to 0.1 milliohm and/or less than/equal to 1 milliohm.

7. Method according to one of the preceding claims, in which the rheostat (27) is set to the second reference resistance (R1), preferably for a period of at least 3 and/or at most 30 milliseconds, at least once, in particular 10 times, a second.

8. Method for charging a chargeable voltage source (5), in which a measuring arrangement (26) is used to determine the voltage of this voltage source (5) and in which the measuring arrangement (26) is first of all checked according to one of the preceding methods, wherein the voltage source (5) is then charged on the basis of a result of this check.

9. Method according to one of the preceding claims, which is carried out on a submarine.

**Revendications**

1. Procédé de contrôle d'un arrangement de mesure (26) destiné à la détermination d'une tension, avec lequel un voltmètre (15) est relié à une source de tension (5) au moyen de lignes électriques (20, 25) et avec lequel une résistance de réglage (27), réglable à une première et à une deuxième (R1) résistance de référence, est branchée en parallèle avec le voltmètre (15), au moins l'une des lignes électriques (20, 25) entre la source de tension (5) et le voltmètre (15) étant contrôlée à l'aide de mesures de tension successives avec la première et la deuxième (R1) résistance de référence réglée de la résistance de réglage (27), **caractérisé en ce que** les résultats des mesures de tension sont utilisés pour déterminer une résistance de ligne (RL1, RL2) d'une ou des lignes électriques (20, 25) au moyen desquelles le voltmètre (15) et la source de tension (5) sont reliés ensemble.

2. Procédé selon la revendication 1, avec lequel la résistance de réglage (27) est formée par une résistance électrique (R1) et un commutateur (S1) branché en série avec celle-ci, la première résistance de référence étant réglée en ouvrant le commutateur (S1) et la deuxième (R1) résistance de référence étant réglée en fermant le commutateur (S1).

3. Procédé selon la revendication 1 ou 2, avec lequel la résistance de réglage (27) est reliée à l'une des ou aux lignes électriques (20, 25) respectivement de manière équipotentielle à un potentiel du voltmètre (15).

4. Procédé selon l'une des revendications 1 à 3, avec lequel les résultats des mesures de tension et/ou leur rapport et/ou leur différence et/ou la résistance de ligne (RL1, RL2) est/sont soumis à une comparaison avec des valeurs comparatives prédéterminées, le résultat de cette comparaison étant utilisé pour l'évaluation d'une modification de la résistance de ligne (RL1, RL2).

5. Procédé selon l'une des revendications précédentes, lequel est mis en oeuvre pour contrôler un arrangement de mesure destiné à la détermination d'une tension aux bornes d'au moins une batterie ou cellule de batterie, notamment une batterie ou cellule de batterie au lithium-ion (5).

6. Procédé selon l'une des revendications précédentes, avec lequel un voltmètre (15) ayant une résistance de mesure ($R_{MEss}$) d'au moins un gigaohm est utilisé et/ou avec lequel la deuxième (R1) résistance de référence est égale ou supérieure à 1 ohm et/ou inférieure ou égale à 10 ohms, notamment égale à 2 ohms et/ou lequel est mis en oeuvre au niveau d'une source de tension ayant une résistance interne (Ri) égale ou supérieure à 0,1 milliohm et/ou inférieure ou égale à 1 milliohm.

7. Procédé selon l'une des revendications précédentes, avec lequel la résistance de réglage (27) est réglée au moins 1, de préférence 10 fois par seconde à la deuxième résistance de référence (R1), de préférence pendant une durée d'au moins 3 et/ou d'au plus 30 millisecondes.

8. Procédé de charge d'une source de tension (5) chargeable, avec lequel est utilisé un arrangement de mesure (26) destiné à la détermination de la tension de cette source de tension (5) et avec lequel un contrôle de l'arrangement de mesure (26) selon l'un des procédés précédents est tout d'abord effectué, la source de tension (5) étant ensuite chargée en fonction d'un résultat de ce contrôle.

9. Procédé selon l'une des revendications précédentes, lequel est mis en oeuvre sur un sous-marin.

Fig. 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1378757 A2
- JP H09112912 A
- DE 4411428 A1
- US 2011121789 A1
- US 6504417 B1